(19) Europäisches Patentamt
European Patent Office
Office européen des brevets

(11) **EP 4 102 615 B1**

(12) **EUROPEAN PATENT SPECIFICATION**

(45) Date of publication and mention
of the grant of the patent:
**18.02.2026 Bulletin 2026/08**

(21) Application number: **21823006.8**

(22) Date of filing: **03.06.2021**

(51) International Patent Classification (IPC):
$G01R\ 31/392$ (2019.01)    $B60L\ 3/00$ (2019.01)
$H01M\ 10/42$ (2006.01)    $H01M\ 10/052$ (2010.01)
$H01M\ 10/48$ (2006.01)    $G01R\ 31/28$ (2006.01)
$G01R\ 35/00$ (2006.01)

(52) Cooperative Patent Classification (CPC):
**G01R 31/392; B60L 3/0046; H01M 10/052;**
**H01M 10/425; H01M 10/486;** B60L 2240/545;
B60L 2240/547; B60L 2250/10; B60L 2260/50;
G01R 31/2829; G01R 35/00; H01M 2010/4271;
Y02E 60/10; Y02T 10/70

(86) International application number:
**PCT/CN2021/098055**

(87) International publication number:
**WO 2021/249269 (16.12.2021 Gazette 2021/50)**

(54) **EARLY WARNING METHOD AND APPARATUS, DEVICE AND STORAGE MEDIUM**

FRÜHWARNVERFAHREN UND -VORRICHTUNG, VORRICHTUNG UND SPEICHERMEDIUM

PROCÉDÉ ET APPAREIL D'AVERTISSEMENT PRÉCOCE, DISPOSITIF ET SUPPORT
D'INFORMATIONS

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**

(30) Priority: **08.06.2020 CN 202010511835**

(43) Date of publication of application:
**14.12.2022 Bulletin 2022/50**

(73) Proprietor: **China Faw Co., Ltd.**
**Changchun, Jilin 130011 (CN)**

(72) Inventors:
- **ZHANG, Di**
**Changchun, Jilin 130011 (CN)**
- **LIU, Yixin**
**Changchun, Jilin 130011 (CN)**
- **LIU, Yongshan**
**Changchun, Jilin 130011 (CN)**
- **RONG, Changru**
**Changchun, Jilin 130011 (CN)**
- **LI, Xue**
**Changchun, Jilin 130011 (CN)**
- **WANG, Shuyang**
**Changchun, Jilin 130011 (CN)**

(74) Representative: **Penza, Giancarlo**
**Bugnion S.p.A.**
**Viale Lancetti, 17**
**20158 Milano (IT)**

(56) References cited:
CN-A- 108 736 079    CN-A- 110 370 984
CN-A- 110 967 642    CN-A- 111 653 840
CN-U- 207 274 442    CN-U- 210 442 486
US-A1- 2019 302 188

- KANG YONGZHE ET AL: "Online multi-fault
detection and diagnosis for battery packs in
electric vehicles", APPLIED ENERGY, ELSEVIER
SCIENCE PUBLISHERS, GB, vol. 259, 30
November 2019 (2019-11-30), XP085975508,
ISSN: 0306-2619, [retrieved on 20191130], DOI:
10.1016/J.APENERGY.2019.114170

## Description

### Technical Field

The disclosure relates to the technical field of vehicles, for example, to an early warning method and apparatus, a device and a storage medium.

### Background

Safety problem of lithium-ion batteries is a major obstacle in the way of its large-scale application in electric vehicles. As the energy density of lithium-ion batteries keeps increasing, it is increasingly urgent to improve the safety of lithium-ion batteries for the development of electric vehicles. Being a key issue in research on battery safety, thermal runaway is also an important and difficult point for early warning of battery faults of a battery management system. In the related art, an early warning method for battery thermal runaway of a battery management system performs safety prevention usually by emphatically determining a rate of temperature change, or by adding a smoke sensor, a gas sensor and other devices. However, in the above method, determination from the dimension of temperature change is susceptible to sampling accuracy and characteristics of a temperature sensor, resulting in a risk of misreport. In addition, although the addition of the smoke sensor and the gas sensor can ensure the accuracy of early warning from multiple dimensions, a potential risk of function failure and system cost are increased.

Patent document CN210442486U discloses a thermal runaway detection circuit; however the problem in the related art still remain.

### Summary

The claimed invention provides an early warning method according to claim 1, an early warning apparatus according to claim 7, a computer device according to claim 8 and a computer-readable storage medium according to claim 9.

The disclosure provides an early warning method and apparatus, a device and a storage medium, which may accurately give early warning of battery thermal runaway, and give an early warning prompt to a user.

An embodiment of the disclosure provides an early warning method. The method includes:

acquiring a battery cell voltage and a battery module temperature in real time;
computing a battery characteristic parameter according to the battery cell voltage and the battery module temperature; and
giving early warning under a condition that the battery characteristic parameter satisfies a preset condition.

An embodiment of the disclosure further provides an early warning apparatus. The apparatus includes:

an acquisition module configured to acquire a battery cell voltage and a battery module temperature in real time;

a computation module configured to compute a battery characteristic parameter according to the battery cell voltage and the battery module temperature; and

an early warning module configured to give early warning under a condition that the battery characteristic parameter satisfies a preset condition.

An embodiment of the disclosure further provides a computer device. The computer device includes a memory, a processor, and a computer program that is stored on the memory and may run on the processor, the processor implementing the above early warning method when executing the program.

An embodiment of the disclosure further provides a computer-readable storage medium. The computer-readable storage medium stores a computer program, the program implementing the above early warning method when executed by a processor.

### Brief Description of the Drawings

Fig. 1A is a flow diagram of an early warning method in Embodiment 1 of the disclosure;

Fig. 1B is a schematic diagram of a thermal runaway apparatus of a battery management system in Embodiment 1 of the disclosure;

Fig. 1C is a schematic diagram of a topological structure of a battery management system in Embodiment 1 of the disclosure;

Fig. 2 is a structural schematic diagram of an early warning apparatus in Embodiment 2 of the disclosure; and

Fig. 3 is a structural schematic diagram of a computer device in Embodiment 3 of the disclosure.

## Detailed Description of the Embodiments

It should be noted in the following embodiments that like numerals and letters denote like items in the following accompanying drawings, and therefore, once an item is defined in one accompanying drawing, it is not required to be further defined and explained in the subsequent accompanying drawings. Moreover, in the descriptions of the disclosure, the terms "first", "second", etc. are merely used to distinguish between descriptions and may not be understood as indication or implication of relative importance.

Embodiment 1

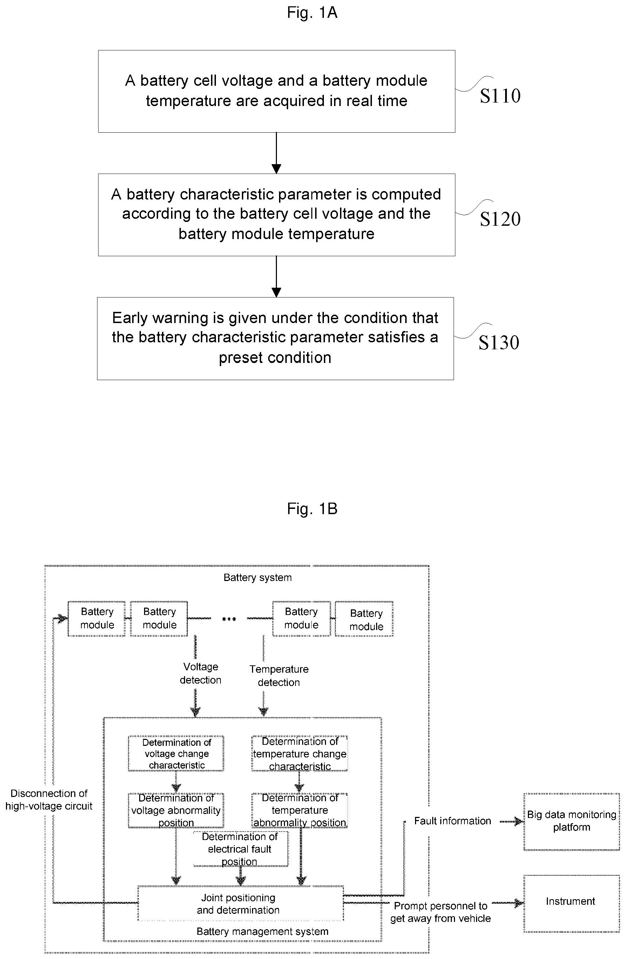

Fig. 1A is a flow diagram of an early warning method provided in Embodiment 1 of the disclosure, and the embodiment is applicable to an early warning condition. This method may be executed by an early warning apparatus in an embodiment of the disclosure, and this apparatus may be realized by at least one mode of software and hardware. As shown in Fig. 1A, this method specifically include the following steps:

S110: a battery cell voltage and a battery module temperature are acquired in real time;

S120: a battery characteristic parameter is computed according to the battery cell voltage and the battery module temperature; and

S130: early warning is given under the condition that the battery characteristic parameter satisfies a preset condition.

In an embodiment, before the step of giving early warning under the condition that the battery characteristic parameter satisfies a preset condition, the method further includes: a circuit condition is determined according to the battery characteristic parameter.

The step of giving early warning under the condition that the battery characteristic parameter satisfies a preset condition includes: the early warning is given under the condition that the battery characteristic parameter and the circuit condition satisfy preset conditions.

In an embodiment, the battery characteristic parameter includes at least one of a maximum battery module temperature, a minimum battery module temperature, a sampling point corresponding to the maximum battery module temperature, a sampling point corresponding to the minimum battery module temperature, a maximum battery cell voltage, a minimum battery cell voltage, a sampling point corresponding to the maximum battery cell voltage, a sampling point corresponding to the minimum battery cell voltage, an average battery module temperature, a temperature of a sampling point corresponding to a temperature adjacent to the maximum battery module temperature, a temperature of a sampling point corresponding to a temperature adjacent to the minimum battery module temperature, a rate of change of the maximum battery module temperature, a rate of change of the temperature adjacent to the maximum battery module temperature in the same battery module, a difference between the maximum battery module temperature and the average battery module temperature, a difference between a temperature of a sampling point adjacent to the sampling point corresponding to the maximum battery module temperature and the average battery module temperature, and a rate of change of the minimum battery cell voltage.

In an embodiment, the circuit condition includes at least one of an open-circuit fault of a battery cell voltage sampling circuit, an open-circuit fault of a temperature sensor sampling circuit, a short-circuit fault of the temperature sensor sampling circuit, a fault of a sampling board communication circuit, a fault of a sampling board power supply circuit and an abnormality of a communication response identifier of a sampling board.

The circuit condition includes a circuit normal condition and a circuit fault. The circuit fault includes at least one of the open-circuit fault of the battery cell voltage sampling circuit, the open-circuit fault of the temperature sensor sampling circuit, the short-circuit fault of the temperature sensor sampling circuit, the fault of the sampling board communication circuit, the fault of the sampling board power supply circuit and the abnormality of the communication response identifier of the sampling board. The circuit normal condition includes at least one of a normal condition of the battery cell voltage sampling circuit, a normal condition of the temperature sensor sampling circuit, a normal condition of the sampling board communication circuit, a normal condition of the sampling board power supply circuit and a normal condition of the communication response identifier of the sampling board. The above conditions are not limited in the embodiment.

In an embodiment, the step of determining a circuit condition according to the battery characteristic parameter includes: under the conditions that a difference between a maximum battery cell voltage and a minimum battery cell voltage is greater than a voltage difference threshold of an open-circuit fault of a cell voltage sampling circuit, and a difference between a position number of a sampling point corresponding to the maximum battery cell voltage and a position number of a sampling point corresponding to the minimum battery cell voltage is equal to 1, that is, the sampling point of the maximum voltage and the sampling point of the minimum voltage are adjacent to each other, determine that an open-circuit fault occurs on a sampling circuit that is in a middle of the sampling point corresponding to the maximum battery cell voltage and the sampling point corresponding to the minimum battery cell voltage, a maximum position number of a sampling point being the number of sampling points. The voltage difference threshold of the open-circuit fault of the cell voltage sampling circuit may be set by a system or by a person, which is not limited in the embodiment.

In an embodiment, the step of determining a circuit condition according to the battery characteristic parameter includes: under the condition that a voltage of a temperature sensor is greater than a voltage threshold, determine that an open-circuit fault or a short-circuit fault occurs on a temperature sensor sampling circuit. The voltage threshold may be set by a system or a person, which is not limited in this embodiment. As an example embodiment, the voltage of the temperature sensor is acquired, and under the condition that the voltage of the temperature sensor is greater than the voltage threshold, it is determined that an open-circuit fault or a short-circuit fault occurs on the temperature sensor sampling circuit.

In an embodiment, the step of determining a circuit condition according to the battery characteristic parameter includes: at least one condition of a fault of a sampling board communication circuit and a fault of a sampling board power supply circuit is determined under the conditions that at least one of battery cell voltage data and battery module temperature data uploaded by a sampling board is not updated, and a communication response identifier of the sampling board is abnormal.

In an embodiment, the step of giving early warning under the condition that the battery characteristic parameter satisfies a preset condition includes: the early warning is given under the conditions that a maximum battery module temperature is greater than a battery temperature abnormality threshold of battery thermal runaway, a minimum battery cell voltage is less than a battery cell voltage abnormality threshold of battery thermal runaway, a difference between a minimum battery cell voltage in a current sampling period and a minimum battery cell voltage in a previous sampling period is greater than a first threshold, and a sampling point corresponding to the maximum battery module temperature and a sampling point corresponding to the minimum battery cell voltage are positioned in the same battery module. The first threshold is a ratio of a threshold of a rate of change of the minimum battery cell voltage to preset times a battery cell voltage data sampling period.

The preset times may be set as required, and for the current solution, the preset times may be set as 1-5 times.

In an embodiment, the step of giving early warning under the condition that the battery characteristic parameter satisfies a preset condition includes: the early warning is given under the conditions that a maximum battery module temperature is greater than a battery temperature abnormality threshold of battery thermal runaway, a difference between a temperature of a sampling point corresponding to a maximum temperature in a current detection period and a temperature of a sampling point corresponding to a maximum temperature in a previous sampling and detection period is greater than a second threshold, and within preset times a battery module temperature data sampling period, a difference between a maximum battery module temperature and an average battery module temperature is greater than a change threshold of the difference between the maximum battery module temperature and the average battery module temperature. The second threshold is a ratio of a threshold of a rate of change to a determination period of a rate of change.

The preset times may be set as required, and for the current solution, the preset times may be set as 10-20 times.

The change threshold of the difference between the maximum temperature and the average temperature may be 20°C - 25°C.

The rate of change includes at least one of a rate of rapid-speed change and a rate of extreme-speed change, a determination period of the rate of rapid-speed change is first preset times a battery module temperature data sampling period, and a determination period of the rate of extreme-speed change is second preset times a battery module temperature data sampling period. The first preset times may be 20-30 times, and the second preset times may be 10-20 times.

In an embodiment, the step of giving early warning under the condition that the battery characteristic parameter satisfies a preset condition includes: the early warning is given under the conditions that a maximum battery module temperature is greater than a battery temperature abnormality threshold of battery thermal runaway, a difference between a temperature adjacent to a maximum temperature in a current sampling period and a temperature adjacent to a maximum temperature in a previous sampling period is greater than a second threshold, and a difference between a previous temperature or a subsequent temperature adjacent to the maximum battery module temperature and an average battery module temperature is greater than a change threshold of the difference between the temperature adjacent to the maximum battery module temperature and the average battery module temperature.

A temperature adjacent to a maximum temperature may be a previous temperature adjacent to the maximum temperature, may be a subsequent temperature adjacent to the maximum temperature, or may include both the previous temperature adjacent to the maximum temperature and the subsequent temperature adjacent to the maximum temperature, which is not limited in the embodiment.

In an embodiment, under the condition that a position number of a sampling point corresponding to a maximum battery module temperature is equal to 1, a temperature adjacent to the maximum temperature is a subsequent temperature adjacent to the maximum temperature. Under the condition that a position number of a sampling point corresponding to a maximum battery module temperature is equal to the number of battery module temperature sampling points, a sampling point corresponding to a temperature adjacent to the maximum temperature is a sampling point corresponding to a previous temperature adjacent to the maximum temperature. A change threshold of a difference between a temperature adjacent to a maximum temperature and an average temperature may be 10°C - 25°C.

In an embodiment, the step of giving the early warning under the condition that the battery characteristic parameter and the circuit condition satisfy preset conditions includes: the early warning is given under the conditions that a maximum battery module temperature is greater than a battery temperature abnormality threshold of battery thermal runaway, an open-circuit fault occurs on a battery cell voltage sampling circuit, a sampling point of the maximum battery module temperature and an open-circuit fault point of the battery cell voltage sampling circuit are positioned in the same module, and a temperature sensor is in a normal working state.

In an embodiment, the step of giving the early warning under the condition that the battery characteristic parameter and the circuit condition satisfy preset conditions includes: the early warning is given under the conditions that a maximum battery module temperature is greater than a battery temperature abnormality threshold of battery thermal runaway, a temperature sensor is in a normal working state, a communication response identifier of a sampling board is abnormal, a sampling point of the maximum battery module temperature and an abnormality point of the communication response identifier of the sampling board are positioned in the same module, and time when the maximum battery module temperature is greater than the battery temperature abnormality threshold of battery thermal runaway is earlier than time when the communication response identifier of the sampling board is abnormal.

Or, the step of giving the early warning under the condition that the battery characteristic parameter and the circuit condition satisfy preset conditions includes: the early warning is given under the conditions that a difference between a temperature of a sampling point corresponding to a maximum temperature in a current detection period and a temperature of a sampling point corresponding to a maximum temperature in a previous sampling and detection period is greater than a second threshold, within preset times a battery module temperature data acquisition period, a difference between a maximum battery module temperature and an average battery module temperature is greater than a change threshold of the difference between the maximum battery module temperature and the average battery module temperature, a temperature sensor fault occurs, time of a temperature change is earlier than time of the temperature sensor fault, a battery cell voltage sampling circuit is normal, a minimum battery cell voltage is less than a battery cell voltage abnormality threshold of battery thermal runaway, and a difference between the minimum battery cell voltage in a current sampling period and a minimum battery cell voltage in a previous sampling period is greater than a first threshold, the first threshold being a ratio of a threshold of a rate of change of the minimum battery cell voltage to preset times a battery cell voltage data sampling period, and the second threshold being a ratio of a threshold of a rate of change to a determination period of a rate of change.

According to the embodiment, with a daisy chain based topological structure of a battery management system, by using change characteristics of maximum and minimum battery temperatures and a method for positioning an electrical fault of a battery management system caused by battery thermal runaway, early warning of battery thermal runaway may be accurately given. Moreover, an early warning prompt is given on a vehicle instrument to a user, and meanwhile, fault information may be uploaded to a big data monitoring platform. As shown in Fig. 1B, according to the technical solution of the disclosure, a fault position where thermal runaway occurs may be positioned by means of diagnosis, which may provide reference information for subsequent vehicle maintenance and fault analysis, and is conducive to design improvement of battery system structure and arrangement. At first, battery cell voltage data and temperature data are required to be acquired in real time, and change characteristics of maximum and minimum battery cell voltages and maximum and minimum temperatures and abnormality positions are required to be identified and verified. The step of identifying and verifying change characteristics of maximum and minimum battery cell voltages and maximum and minimum temperatures and abnormality positions includes the following steps: step 1, battery cell voltage data and battery module temperature data are acquired in real time by a slave sampling board of a battery management system, a battery cell voltage data array and a battery module temperature data array are established by means of a master control board of the battery management system, and the assignment is carried out: battery cell voltage data array: CellVol[n], battery module temperature data array: ModuleTemp[m], n being the number of cell voltage sampling points of a battery system, and m being the number of battery module temperature sampling points of the battery system. Step 2: data in the battery cell voltage data array and the battery module temperature data array is processed in real time, and a minimum battery cell voltage, a maximum battery cell voltage, a sampling point corresponding to the minimum battery cell voltage, a sampling point corresponding to the maximum battery cell voltage, a minimum battery module temperature, a maximum battery module temperature, a sampling point corresponding to the minimum battery module temperature, a sampling point corresponding to the maximum battery module temperature and an average battery module temperature are computed: f [Vmin, NumVmin] = Min(CellVol[n]), f[Vmax, NumVmax] = Max(CellVol[n]), [Tmin, NumTmin] = Min(ModuleTemp[m]), f [Tmax, NumTmax] = Max(ModuleTemp[m]), Tavg=Sum(ModuleTemp[m])/m, Vmin being the minimum battery cell voltage, NumVmin being the sampling point of the minimum battery cell voltage, Tmax being the maximum battery module temperature, NumTmax being the sampling point of the maximum battery module temperature, and Tavg being the average battery module temperature. Step 3: a temperature of a sampling point of a temperature adjacent to the maximum battery module temperature, and a temperature of a sampling point of a temperature adjacent to the minimum battery module temperature are computed: Tmaxf = ModuleTemp[NumTmax-1], Tmaxb=ModuleTemp[NumTmax+1], Tmaxf being a temperature of a previous sampling point of the maximum battery module temperature, and Tmaxb being a temperature of a next sampling point of the maximum battery module temperature. In the case of NumTmax = 1, Tmaxf = Tmax; and in the case of NumTmax = m, Tmaxb = Tmax. . Step 4: a rate of change of the maximum battery module temperature is computed, for example, in order to ensure accuracy of identifying the rate of change of the maximum battery module temperature, in consideration of an influence of battery energy density on a temperature rise rate and a rapid-speed performance and an extreme-speed performance of a battery module temperature change, the rate of change of the maximum battery module temperature is computed: rate of rapid-speed change: $\triangle$Tmax1 = Tmax(i) - Tmax(i-1), rate of extreme-speed change: $\triangle$Tmax2 = Tmax(j) - Tmax(j-1), Tmax(i) and Tmax(j) each being a temperature of a sampling point corresponding to the maximum temperature in a current detection period, Tmax(i-1) and Tmax(j-1) each being a temperature of a sampling point corresponding to a maximum temperature in a previous detection period, and the detection period of $\triangle$Tmax1 being longer than the detection period of $\triangle$Tmax1. Step 5: a rate of change of a temperature adjacent to a maximum battery module temperature in the same battery module is computed, for example, considering that when battery thermal runaway occurs, an adjacent temperature sampling point may also have a rapid temperature rise change due to an influence of heating of a fault battery cell, and meanwhile, interference of abnormal sampling of a sensor at a sampling point of the maximum battery module temperature is eliminated, the rate of change of the temperature adjacent to the maximum battery module temperature is computed: $\triangle$Tmaxf = Tmaxf(k) - Tmaxf(k-1), $\triangle$Tmaxb = Tmaxb(k) - Tmaxb(k-1), Tmaxf(k) and Tmaxb(k) each being a temperature of an adjacent sampling point in a current sampling period, and Tmaxf(k-1) and Tmaxb(k-1) each being a temperature of an adjacent sampling point in a previous sampling period. Step 6: change characteristics of a difference between the maximum battery module temperature and the average battery module temperature and a difference between the adjacent temperature and the average battery module temperature are identified, for example, considering that battery thermal runaway is possibly caused by an abnormality of one cell, identify the change characteristics of the difference between the maximum battery module temperature and the average battery module temperature and the difference between the adjacent temperature and the average battery module temperature: $\triangle$T = Tmax - Tavg, $\triangle$Tf = Tmaxf - Tavg, $\triangle$Tb = Tmaxb - Tavg, $\triangle$T being the difference between the maximum battery module temperature and the average battery module temperature, $\triangle$Tf being the difference between a previous temperature adjacent to the maximum battery module temperature and the average battery module temperature, and $\triangle$Tb being the difference between a subsequent temperature adjacent to the maximum battery module temperature and the average battery module temperature. Step 7: in consideration of an influence of battery thermal runaway on battery temperature characteristics, an influence of battery thermal runaway on a battery cell voltage change is identified, for example, a rate of change of the minimum battery cell voltage is computed: $\triangle$Vmin = Vmin(k)Vmin(k-1), Vmin(k) being a minimum cell voltage in a current sampling period, and Vmin(k-1) being a minimum cell voltage in a previous sampling period. Step 8: give early warning of battery thermal runaway by integrating computed data in the steps 4-7: Determination working condition 1 of battery thermal runaway:

Condition (1):

$$Vmin < Vrt$$

Condition (2):

$$\triangle Vmin > V1/t4$$

Condition (3):

$$Tmax > Trt$$

Condition (4): NumTmax and NumVmin are in the same battery module

In the case that all the conditions (1) - (4) are satisfied, an early warning identifier 1 of thermal runaway is set as 1.

Vrt is a cell voltage abnormality threshold of battery thermal runaway, Trt is a battery temperature abnormality threshold of battery thermal runaway, Vl is a threshold of a rate of change of a minimum battery cell voltage and ranges from 1 V - 4 V, t4 is 1-5 times a battery cell voltage data sampling period.

Determination working condition 2 of battery thermal runaway:

Condition (1):

$$Tmax > Trt$$

Condition (2):

$$\triangle Tmax1 > T1/t1 \text{ or } \triangle Tmax2 > T2/t2$$

Condition (3):

$$\triangle T > T3 \text{ and hold time} > t3$$

In the case that all the conditions (1) - (3) are satisfied, an early warning identifier 2 of thermal runaway is set as 1.

In the condition (2), in order to ensure accuracy of identifying the rate of change of the maximum battery module temperature, in consideration of an influence of battery energy density on a temperature rise rate and a rapid-speed performance and an extreme-speed performance of a battery module temperature change, change characteristics of the maximum battery module temperature is subjected to double-rate identification. $\triangle Tmax1$ represents a rapid-speed condition, T1 is a rate of rapid-speed change threshold and ranges from 1°C to 3°C, t1 is a determination period of a rate of rapid-speed change and ranges from 20 times to 30 times a battery module temperature data sampling period. $\triangle Tmax2$ represents an extreme-speed condition, T2 is a rate of extreme-speed change threshold and ranges from 2°C to 5°C, t2 is a determination period of a rate of extreme-speed change and ranges from 5 times to 10 times a battery module temperature data sampling period.

In the condition (3), T3 is a change threshold of a difference between the maximum battery module temperature and the average battery module temperature and ranges from 20°C to 25°C, and t3 is hold time of the difference between the maximum battery module temperature and the average battery module temperature and ranges from 10 times to 20 times a battery module temperature data sampling period.

Determination working condition 3 of battery thermal runaway:

Condition (1):

$$Tmax > Trt$$

Condition (2):

$$\triangle Tmaxf > T1/t1 \text{ or } \triangle Tmaxb > T1/t1$$

Condition (3).

$$\triangle Tf > T4 \text{ or } \triangle Tb > T4 \text{ and hold time} > t3$$

In the case that all the conditions (1)-(3) are satisfied, an early warning identifier 3 of thermal runaway is set as 1.

T4 is a change threshold of a difference between a temperature adjacent to the maximum temperature and an average temperature and ranges from 10°C to 25°C.

Considering that when battery thermal runaway occurs, a sampling point corresponding to an adjacent temperature may also have a rapid temperature rise change due to an influence of heating of a fault battery cell, and meanwhile, interference of abnormal sampling of a sensor at a sampling point of the maximum battery module temperature is eliminated, change characteristics of the adjacent temperature in the same battery module where the maximum battery module temperature is rapidly identified. At least one of $\triangle$Tmaxf and $\triangle$XTmaxb may be selected and used according to the number of single battery module temperature sampling points. In the case of NumTmax = 1, only a determination result of $\triangle$Tmaxb is used; and in the case of NumTmax = m, only a determination result of $\triangle$Tmaxf is used.

Any early warning identifier of thermal runaway of the determination working conditions 1-3 is set as 1, the battery management system gives an early warning signal of battery thermal runaway, and in the case that the early warning identifiers of thermal runaway of the determination working conditions 1-3 are not set as 1, a process for diagnosing battery thermal runaway by jointly identifying a battery characteristic change and an electrical fault of a battery management system is carried out.

When battery thermal runaway occurs, cell voltage and temperature data sampling circuits of the battery management system may be affected, such that sampled data is abnormal, and accuracy of the sampled data may not be ensured. Moreover, battery thermal runaway may further affect data transmission, a communication circuit and a sampling board power supply circuit of the battery management system. These electrical faults of the battery management system will make data not capable of being updated in time, or even block data transmission, resulting in risks that faults are misreported and not reported. In consideration of the above conditions, the data sampling circuit, the communication circuit and the sampling board power supply circuit of the battery management system are identified, and in combination with the above method for identifying and verifying change characteristics of maximum and minimum battery cell voltages and maximum and minimum temperatures and an abnormality position, a position where thermal runaway of a battery system occurs is more accurately identified, and moreover, accuracy of early warning of battery thermal runaway is improved.

In an embodiment, the step of identifying and verifying change characteristics of maximum and minimum battery cell voltages and maximum and minimum temperatures and an abnormality position includes the following steps: step 10, an open-circuit fault of a battery cell voltage sampling circuit is identified according to a voltage change and a voltage difference of adjacent battery cells, and a fault position is identified.

$$\triangle V = Vmax\text{-}Vmin$$

Identification of cell voltage difference:

$$\triangle V > V2$$

Identification of voltage difference position:

$$|NumVmax - NumVmin| = 1$$

V2 is a voltage difference threshold of an open-circuit fault of a cell voltage sampling circuit.

In the case that the above conditions are satisfied, it is determined that an open-circuit fault occurs on a sampling circuit in a middle of a sampling point of a maximum cell voltage and a sampling point of a minimum cell voltage.

Step 20: range determination is carried out according to a sampled value of a maximum battery module temperature and a sampled value of a minimum battery module temperature, an open-circuit fault or a short-circuit fault of a temperature sensor sampling circuit is identified, and meanwhile, a fault position is identified. Under the condition that the maximum battery module temperature and the minimum battery module temperature exceed a temperature sensor sampling temperature range, it is determined that an open-circuit fault or a short-circuit fault of a temperature sensor sampling circuit occurs on a temperature sampling point exceeding the range.

Step 30: when faults of a sampling board communication circuit and a sampling board power supply circuit of a battery management system occur, which is embodied in a condition that battery cell voltage and module temperature data uploaded by an abnormal sampling board is not updated any more, and a communication response identifier of the sampling board is abnormal, a fault position is identified according to the data and abnormality of the response identifier.

Step 40: a thermal runaway fault is jointly positioned in combination with a battery module temperature change, a cell voltage change and the conditions in the steps 10-30.

Determination working condition 4 of battery thermal runaway:

Condition (1):

$$Tmax > Trt$$

Condition (2): an open-circuit fault occurs on a battery cell voltage sampling circuit

Condition (3): NumTmax and an open-circuit fault point of the battery cell voltage sampling circuit are positioned in the same module

Condition (4): no temperature sensor fault

In the case that all the conditions (1) - (4) are satisfied, an early warning identifier 4 of thermal runaway is set as 1.
Determination working condition 5 of battery thermal runaway:

Condition (1):

$$Tmax > Trt$$

Condition (2): no temperature sensor fault

Condition (3): a communication response identifier of a sampling board is abnormal

Condition (4): NumTmax and an abnormality point of a communication response identifier of a sampling board are positioned in the same module

Condition (5): time of Tmax > Trt is earlier than a communication response identifier of a sampling board is abnormal

In the case that all the conditions (1) - (5) are satisfied, the early warning identifier 5 of thermal runaway is set as 1.
Determination working condition 6 of battery thermal runaway:

Condition (1):

$$\triangle Tmax > T1/t1 \text{ or } \triangle Tmax > T2/t2$$

Condition (2):

$$\triangle T > T3 \text{ and hold time} > t3$$

Condition (3): a fault occurs on a temperature sensor

Condition (4): time of a temperature change is earlier than time of a temperature sensor fault

Condition (5): no open-circuit fault of a battery cell voltage sampling circuit

Condition (6):

$$Vmin < Vrt$$

Condition (7):

$$\triangle Vmin > V1/t4$$

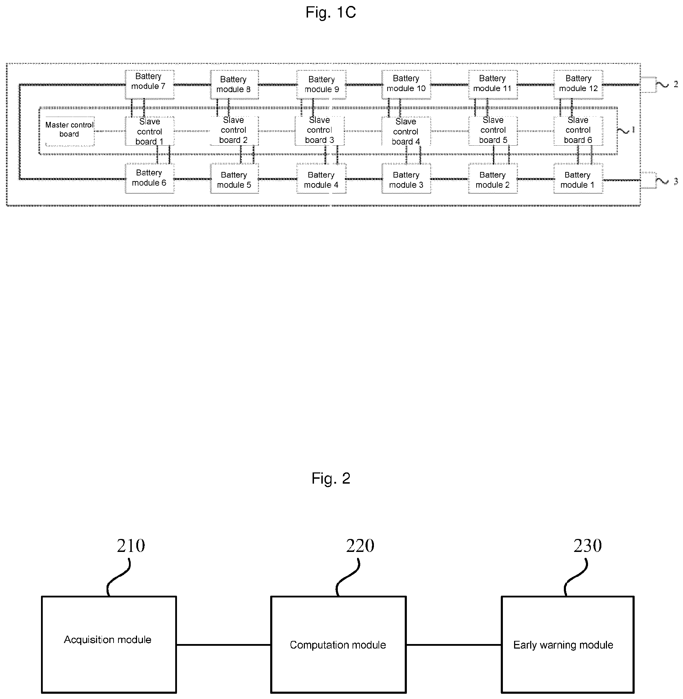

In the case that all the conditions (1) - (7) are satisfied, an early warning identifier 6 of thermal runaway is set as 1.
Any early warning identifier of thermal runaway of the determination working conditions 4 and 5 is set as 1, a battery management system gives an early warning signal of battery thermal runaway, and in the case that the early war identifiers of thermal runaway of the determination working conditions 4 and 5 are not set as 1, a process for diagnosing battery thermal runaway by identifying a battery characteristic change is carried out again.
After a battery thermal runaway fault is diagnosed through the above method, the battery management system may control a high-voltage circuit to be disconnected, reports the battery thermal runaway fault to an instrument, prompts a user to immediately get away from a vehicle, and synchronously uploads fault information to a big data monitoring platform.
In an embodiment, as shown in Fig. 1C, the battery management system 1 includes a master control board and six slave control boards, a battery system positive electrode 2 and a battery system negative electrode 3 are arranged separately, battery modules are connected to the master control board or the slave control boards by means of battery management system sampling circuits, the battery modules are connected to each other by means of connecting copper bars between the battery modules, and the master control board is connected to the slave control boards or the slave control boards are connected to each other by means of battery management system communication circuits. According to a topological structure of the battery management system, determination values of determination working conditions 1-6 of battery thermal runaway are set:

Determination working condition 1 of battery thermal runaway:

Condition (1):

$$Vmin < Vrt$$

Condition (2):

$$\triangle Vmin > V1/t4$$

Condition (3):

$$Tmax > Trt$$

Condition (4): NumTmax and NumVmin are in the same battery module

In the case that all the conditions (1) - (4) are satisfied, an early warning identifier 1 of thermal runaway is set as 1.

Determination working condition 2 of battery thermal runaway:

Condition (1):

$$Tmax > Trt$$

condition (2):

$$\triangle Tmax1 > T1/t1 \text{ or } \triangle Tmax2 > T2/t2$$

Condition (3):

$$\triangle T > T3 \text{ and hold time} > t3$$

In the case that all the conditions (1) - (3) are satisfied, an early warning identifier 2 of thermal runaway is set as 1.

Determination working condition 3 of battery thermal runaway:

Condition (1):

$$Tmax > Trt$$

condition (2):

$$\triangle Tmaxf > T1/t1 \text{ or } \triangle Tmaxb > T1/t1$$

Condition (3).

$$\triangle Tf > T4 \text{ or } \triangle Tb > T4 \text{ and hold time} > t3$$

In the case that all the conditions (1)-(3) are satisfied, an early warning identifier 3 of thermal runaway is set as 1.

Determination working condition 4 of battery thermal runaway:

Condition (1):

$$Tmax > Trt$$

Condition (2): an open-circuit fault occurs on a battery cell voltage sampling circuit

Condition (3): NumTmax and an open-circuit fault point of the battery cell voltage sampling circuit are positioned in the same module

Condition (4): no temperature sensor fault

In the case that all the conditions (1) - (4) are satisfied, an early warning identifier 4 of thermal runaway is set as 1.
Determination working condition 5 of battery thermal runaway:

Condition (1):

$$Tmax > Trt$$

Condition (2): no temperature sensor fault

Condition (3): a communication response identifier of a sampling board is abnormal

Condition (4): NumTmax and an abnormality point of a communication response identifier of a sampling board are positioned in the same module

Condition (5): time of Tmax > Trt is earlier than a communication response identifier of a sampling board is abnormal

In the case that all the conditions (1) - (5) are satisfied, the early warning identifier 5 of thermal runaway is set as 1.
Determination working condition 6 of battery thermal runaway:

Condition (1):

$$\triangle Tmax > T1/t1 \text{ or } \triangle Tmax > T2/t2$$

Condition (2):

$$\triangle T > T3 \text{ and hold time} > t3$$

Condition (3): a fault occurs on a temperature sensor

Condition (4): time of a temperature change is earlier than time of a temperature sensor fault

Condition (5): no open-circuit fault of a battery cell voltage sampling circuit

Condition (6):

$$Vmin < Vrt$$

Condition (7):

$$\triangle Vmin > V1/t4$$

In the case that all the conditions (1) - (7) are satisfied, an early warning identifier 6 of thermal runaway is set as 1.
In the embodiment, Trt may be 65°C, 85°C or 100°C, Vrt may be 1 V, 1. 5 V or 2 V, V1 may be 1 V, 2 V or 4 V, T1 may be 1°C, 2°C or 3°C, T2 may be 2°C, 3°C or 5°C, T3 may be 20°C, 23°C or 25°C, T4 may be 10°C, 15°C or 20°C, t1 may be 2 s, 2.5 s or 3 s, t2 may be 500 ms, 800 ms or 1000 ms, t3 may be 1s, 1.5 s or 2 s and t4 may be 100 ms, 300 ms or 500 ms. According to an experimental result, by analyzing a data change after warning is given, a battery thermal runaway fault may also be reported under the determination working conditions 4 and 5 of battery thermal runaway, and a battery thermal runaway fault may be accurately positioned by the technical solution disclosed in the embodiment.

According to the embodiment, battery temperature change characteristics caused by battery thermal runaway and an influence on a battery cell in the same battery module are considered, such that thermal runaway misdiagnosis caused by abnormal sampling of one of the temperature sensors may be avoided. According to a method for positioning an electrical fault of a battery management system caused by battery thermal runaway in the disclosure, thermal runaway misdiagnosis caused by independently determining a battery temperature change trend may be avoided, and accuracy of positioning a position of battery thermal runaway is improved. The topological structure of the battery management system in the embodiment includes, but is not limited to, a distributed topological structure and a centralized topological structure.

In the embodiment, a battery thermal runaway fault is diagnosed and positioned by means of characteristics of a daisy chain based topological structure of a battery management system, and no other gas and pressure sensors are added. Maximum and minimum temperatures caused by battery thermal runaway are verified through a method for identifying change characteristics of sampled values of adjacent temperatures in the same battery module where maximum and minimum temperatures are and change characteristic of differences between the adjacent temperatures and a mean battery temperature, such that accuracy of identifying maximum and minimum temperatures is improved, and fault misreport caused by abnormal sampling of a single temperature sensor is eliminated. Compared with a method by using a single rate of change of a temperature in other related art, the method for identifying rapid-speed and extreme-speed change characteristics of maximum and minimum temperatures caused by battery thermal runaway may better cover a thermal runaway working condition of a high energy density battery. By using maximum and minimum battery module temperature changes, maximum and minimum cell voltage changes, a sampling fault and a communication fault of a battery management system caused by battery thermal runaway for joint diagnosis and positioning, risks that faults are misreported and not reported caused by the conditions that data may not be updated in time and data transmission is blocked due to an electrical fault of a battery management system may be reduced. In terms of handling measures for a battery thermal runaway fault, a current high-voltage disconnection operation and an instrument early warning prompt are considered, and fault information may be synchronously uploaded to a big data monitoring platform, such that positive effects are achieved on after-sales maintenance, big data analysis and battery system design improvement.

In order to effectively detect battery thermal runaway on a pure electric vehicle, the embodiment provides a combination of identification of battery temperature change characteristics and positioning and detection of an electrical fault of a battery management system caused by battery thermal runaway, so as to given early warning according to temperature change characteristics and fault positioning. In the embodiment, a battery thermal runaway fault is diagnosed and positioned by means of characteristics of a daisy chain based topological structure of a battery management system, and no other gas and pressure sensors are added, such that a cost advantage is achieved. Maximum and minimum temperatures caused by battery thermal runaway are verified through a method for identifying change characteristics of sampled values of adjacent temperatures in the same battery module where the maximum and minimum temperatures are and change characteristic of differences between the adjacent temperatures and a mean battery temperature, such that reliability of identifying maximum and minimum temperatures is improved. Compared with a method by using a single rate of change of a temperature in other related art, the method for identifying rapid-speed and extreme-speed change characteristics of maximum and minimum temperatures caused by battery thermal runaway may better cover a thermal runaway working condition of a high energy density battery. By using maximum and minimum battery module temperature changes, maximum and minimum cell voltage changes, a sampling fault and a communication fault of a battery management system caused by battery thermal runaway for joint diagnosis and positioning, risks that faults are misreported and not reported caused by the conditions that data may not be updated in time and data transmission is blocked due to an electrical fault of a battery management system may be reduced.

In terms of handling measures for a battery thermal runaway fault, a current high-voltage disconnection operation and an instrument early warning prompt are considered, and fault information may be synchronously uploaded to a big data monitoring platform, such that positive effects are achieved on after-sales maintenance, big data analysis and battery system design improvement.

According to the technical solution of the embodiment, by acquiring a battery cell voltage and a battery module temperature in real time, computing a battery characteristic parameter according to the battery cell voltage and the battery module temperature, and giving early warning under the condition that the battery characteristic parameter satisfies a preset condition, early warning of battery thermal runaway may be accurately given.

Embodiment 2

Fig. 2 is a structural schematic diagram of an early warning apparatus provided in Embodiment 2 of the disclosure. The embodiment is applicable to an early warning condition, the apparatus may be realized by means of any mode of software and hardware, and the apparatus may be integrated in any device that provides an early warning function. As shown in Fig. 2, the early warning apparatus specifically includes: an acquisition module 210, a computation module 220 and an early warning module 230.

The acquisition module is configured to acquire a battery cell voltage and a battery module temperature in real time;

the computation module is configured to compute a battery characteristic parameter according to the battery cell voltage and the battery module temperature; and

the early warning module configured to give early warning under the condition that the battery characteristic parameter satisfies a preset condition.

The above product may execute the method provided in any embodiment of the disclosure, and has corresponding function modules for executing the method and beneficial effects.

According to the technical solution of the embodiment, by acquiring a battery cell voltage and a battery module temperature in real time, computing a battery characteristic parameter according to the battery cell voltage and the battery module temperature, and giving early warning under the condition that the battery characteristic parameter satisfies a preset condition, early warning of battery thermal runaway may be accurately given.

Embodiment 3

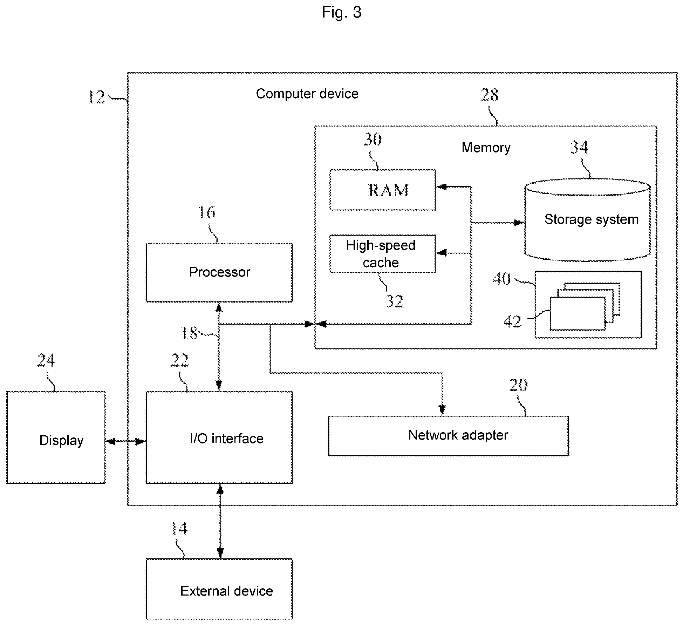

Fig. 3 is a structural schematic diagram of a computer device in Embodiment 3 of the disclosure. Fig. 3 shows a block diagram of a computer device 12 applicable to implementing the implementation. The computer device 12 shown in Fig. 3 is merely an example and should not be construed to limit the functions and scope of use of the embodiments of the disclosure.

As shown in Fig. 3, the computer device 12 is in the form of a general purpose computing device. Components of the computer device 12 may include, but are not limited to: one or more processors or processing units 16, a system memory 28, and a bus 18 that connects various system components (including the system memory 28 and the processing units 16).

The bus 18 represents one or more of several types of buses, including a memory bus or memory controller, a peripheral bus, an accelerated graphics port, and a processor or local bus using any of a variety of buses. For example, theses architectures include, but are not limited to an industry standard architecture (ISA) bus, a micro channel architecture (MAC) bus, an enhanced ISA bus, a video electronics standards association (VESA) local bus, and a peripheral component interconnect (PCI) bus.

The computer device 12 includes a variety of computer system readable media. Such media may be any available media that may be accessed by the computer device 12 and include volatile and non-volatile media, removable and non-removable media.

The system memory 28 may include a computer system readable medium in the form of volatile memory, such as at least one of random access memory (RAM) 30 and cache memory 32. The computer device 12 may also include other removable or non-removable, volatile or non-volatile computer system storage media. Merely for example, the storage system 34 may be used to read from and write to a non-removable and non-volatile magnetic medium (not shown in Fig. 3 and commonly referred to as "hard disk drive"). Although not shown in Fig. 3, a magnetic disk drive for reading from or writing to a removable and non-volatile magnetic disk (such as, a "floppy disk"), and an optical disk drive for reading from or writing to a removable and non-volatile optical disk (such as, a CD-ROM (compact disk read-only memory), DVD-ROM (digital videodisk read-only memory) or other optical media) may be provided. In such cases, each drive may be connected to the bus 18 by means of one or more data medium interfaces. The memory 28 may include at least one program product having a set (for example, at least one) of program modules configured to execute functions of each embodiment of the disclosure.

A program or utility 40 having a set (for example, at least one) of program module 42 may be stored, for example, in the memory 28, the program module 42 includes, but is not limited to, an operating system, one or more application programs, other program modules, and program data, and at least one of these examples of the program module 42 possibly includes a network environment. The program module 42 typically executes one of functions and methods in the embodiments described in the disclosure.

The computer device 12 may also be in communication with one or more peripheral devices 14 (such as a keyboard, a pointing device and a display 24), with one or more devices that enable a user to interact with the computer device 12, or with any device (such as a network card and a modulator-demodulator) that enables the computer device 12 to be in communication with one or more other computing devices. Such communication may be carried out by means of an input/output (I/O) interface 22. In addition, in the computer device 12 in the embodiment, the display 24 is not provided as an independent body, but is embedded in a mirror surface, and when a display surface of the display 24 does not perform display, the display surface of the display 24 and the mirror surface are visually integrated. Moreover, the computer device

**EP 4 102 615 B1**

12 may be in communication with one or more networks (such as, at least one of a local area network (LAN), a wide area network (WAN) and a public network, such as the Internet) by means of a network adapter 20. As shown in Fig. 3, the network adapter 20 is in communication with the other modules of the computer device 12 by means of the bus 18. Although not shown in the figures, at least one of other hardware and software modules may be used in combination with the computer device 12, and other hardware and software modules include but are not limited to: microcode, a device drive, a redundant processing unit, an external disk drive array, a redundant array of independent disks (RAID) system, a tape drive, or data backup storage system, etc.

The processing unit 16 executes a variety of functional applications and process data by executing programs stored in the system memory 28, for example, realizes the early warning method provided in the embodiment of the disclosure, which includes: acquire a battery cell voltage and a battery module temperature in real time; compute a battery characteristic parameter according to the battery cell voltage and the battery module temperature; and give early warning under the condition that the battery characteristic parameter satisfies a preset condition.

Embodiment 4

Embodiment 4 of the disclosure provides a computer-readable storage medium. The computer-readable storage medium stores a computer program, the program implementing, when executed by a processor, the above early warning method provided in the embodiments of the disclosure. The method includes: acquire a battery cell voltage and a battery module temperature in real time; compute a battery characteristic parameter according to the battery cell voltage and the battery module temperature; and give early warning under the condition that the battery characteristic parameter satisfies a preset condition.

Any combination of one or more computer-readable media may be used. The computer-readable medium may be a computer-readable signal medium or a computer-readable storage medium. The computer-readable storage medium may include, but is not limited to, electronic, magnetic, optical, electromagnetic, infrared or semiconductor systems, apparatuses or devices, or any combination of the foregoing. More specific examples (a non-exhaustive list) of the computer-readable storage medium include: an electrical connection based on one or more wires, a portable computer disk, a hard disk, a RAM, a read-only memory (ROM), an erasable programmable read-only memory (EPROM or a flash), an optical fiber, a CD-ROM, an optical storage device, a magnetic storage device or any suitable combination of the foregoing. In the disclosure, a computer-readable storage medium may be any tangible medium that may contain, or store a program that may be used by or in connection with an instruction execution system, apparatus or device.

A computer-readable signal medium may include a propagated data signal that embodies computer-readable program code, either in baseband or as part of a carrier wave. Such a propagated data signal may take any of a variety of forms, including, but not limited to, an electromagnetic signal, an optical signal or any suitable combination of the foregoing. A computer-readable signal medium may also be any computer-readable medium that is not a computer-readable storage medium and that may send, propagate or transport a program that is used by or in combination with an instruction execution system, apparatus or device.

Program code embodied on a computer readable medium may be transmitted by using any appropriate medium, including but not limited to wireless, a wire, an optical fiber cable, a radio frequency (RF), etc., or any suitable combination of the foregoing.

The computer program code for executing an operation of the disclosure may be written in one or more programming languages or a combination thereof, including object orient programming languages such as Java, Smalltalk or C++, and conventional procedural programming languages, such as "C" language or similar programming languages. The program code may be executed entirely on a user computer, executed partially on the user computer, executed as a stand-alone software package, executed partially on the user computer and partially on a remote computer, or executed entirely on the remote computer or a server. Where the remote computer is involved, the remote computer may be connected to the user computer by means of any kind of network, including the local area network (LAN) or the wide area network (WAN), or may be connected to an external computer (the external computer is connected by means of the internet by an internet service provider).

**Claims**

1. An early warning method, comprising:

   acquiring a battery cell voltage and a battery module temperature in real time (S110); computing a battery characteristic parameter according to the battery cell voltage and the battery module temperature (S120); and giving early warning under a condition that the battery characteristic parameter satisfies a preset condition (S130);

**characterized in that**:
the giving early warning under the condition that the battery characteristic parameter satisfies a preset condition comprises one of the following situations:

giving the early warning under the conditions that a maximum battery module temperature is greater than a battery temperature abnormality threshold of battery thermal runaway, a minimum battery cell voltage is less than a battery cell voltage abnormality threshold of battery thermal runaway, a difference between the minimum battery cell voltage in a current sampling period and a minimum battery cell voltage in a previous sampling period is greater than a first threshold, and a sampling point corresponding to the maximum battery module temperature and a sampling point corresponding to the minimum battery cell voltage are positioned in the same battery module, the first threshold being a ratio of a threshold of a rate of change of the minimum battery cell voltage to preset times a battery cell voltage data sampling period;
giving the early warning under the conditions that a maximum battery module temperature is greater than a battery temperature abnormality threshold of battery thermal runaway, a difference between a temperature of a sampling point corresponding to a maximum temperature in a current detection period and a temperature of a sampling point corresponding to a maximum temperature in a previous sampling and detection period is greater than a second threshold, and within preset times a battery module temperature data sampling period, a difference between a maximum battery module temperature and an average battery module temperature is greater than a change threshold of the difference between the maximum temperature and the average temperature, the second threshold being a ratio of a threshold of a rate of change to a determination period of a rate of change; and
giving the early warning under the conditions that a maximum battery module temperature is greater than a battery temperature abnormality threshold of battery thermal runaway, a difference between a temperature adjacent to a maximum temperature in a current sampling period and a temperature adjacent to a maximum temperature in a previous sampling period is greater than a second threshold, and a difference between a previous temperature or a subsequent temperature adjacent to the maximum battery module temperature and an average battery module temperature is greater than a change threshold of the difference between the temperature adjacent to the maximum battery module temperature and the average battery module temperature.

2.  The method according to claim 1, wherein before giving early warning under the condition that the battery characteristic parameter satisfies a preset condition, the method further comprises: determining a circuit condition according to the battery characteristic parameter; and
    the giving early warning under the condition that the battery characteristic parameter satisfies a preset condition comprises: giving the early warning under the condition that the battery characteristic parameter and the circuit condition satisfy preset conditions.

3.  The method according to claim 1 or 2, wherein the battery characteristic parameter comprises at least one of a maximum battery module temperature, a minimum battery module temperature, a sampling point corresponding to the maximum battery module temperature, a sampling point corresponding to the minimum battery module temperature, a maximum battery cell voltage, a minimum battery cell voltage, a sampling point corresponding to the maximum battery cell voltage, a sampling point corresponding to the minimum battery cell voltage, an average battery module temperature, a temperature adjacent to the maximum battery module temperature, a temperature adjacent to the minimum battery module temperature, a rate of change of the maximum battery module temperature, a rate of change of the temperature adjacent to the maximum battery module temperature in the same battery module, a difference between the maximum battery module temperature and the average battery module temperature, a difference between a temperature of a sampling point adjacent to the sampling point corresponding to the maximum battery module temperature and the average battery module temperature, and a rate of change of the minimum battery cell voltage.

4.  The method according to claim 2, wherein the circuit condition comprises at least one of an open-circuit fault of a battery cell voltage sampling circuit, an open-circuit fault of a temperature sensor sampling circuit, a short-circuit fault of the temperature sensor sampling circuit, a fault of a sampling board communication circuit, a fault of a sampling board power supply circuit and an abnormality of a communication response identifier of a sampling board.

5.  The method according to claim 2, wherein the determining a circuit condition according to the battery characteristic parameter comprises one of the following situations:

determining, under the conditions that a difference between a maximum battery cell voltage and a minimum battery cell voltage is greater than a voltage difference threshold of an open-circuit fault of a cell voltage sampling circuit, and a difference between a position number of a sampling point of the maximum battery cell voltage and a position number of a sampling point of the minimum battery cell voltage is equal to 1, that is, the sampling point of the maximum voltage and the sampling point of the minimum voltage are adjacent to each other, that an open-circuit fault occurs on a sampling circuit that is in a middle of the sampling point of the maximum value battery cell voltage and the sampling point of the minimum battery cell voltage;

determining, under the condition that a voltage of a temperature sensor is greater than a voltage threshold, that an open-circuit fault or a short-circuit fault occurs on a temperature sensor sampling circuit; and

determining at least one condition of a fault of a sampling board communication circuit and a fault of a sampling board power supply circuit under the conditions that at least one of battery cell voltage data and battery module temperature data uploaded by a sampling board is not updated, and a communication response identifier of the sampling board is abnormal.

6. The method according to claim 2, wherein the giving the early warning under the condition that the battery characteristic parameter and the circuit condition satisfy preset conditions comprises any one of the following situations:

giving the early warning under the conditions that a maximum battery module temperature is greater than a battery temperature abnormality threshold of battery thermal runaway, an open-circuit fault occurs on a battery cell voltage sampling circuit, a sampling point of the maximum battery module temperature and an open-circuit fault point of the battery cell voltage sampling circuit are positioned in the same module, and a temperature sensor is in a normal working state;

giving the early warning under the conditions that a maximum battery module temperature is greater than a battery temperature abnormality threshold of battery thermal runaway, a temperature sensor is in a normal working state, a communication response identifier of a sampling board is abnormal, a sampling point of the maximum battery module temperature and an abnormality point of the communication response identifier of the sampling board are positioned in the same module, and time when the maximum battery module temperature is greater than the battery temperature abnormality threshold of battery thermal runaway is earlier than time when the communication response identifier of the sampling board is abnormal; and

giving the early warning under the conditions that a difference between a temperature of a sampling point corresponding to a maximum temperature in a current detection period and a temperature of a sampling point corresponding to a maximum temperature in a previous sampling and detection period is greater than a second threshold, within preset times a battery module temperature data acquisition period, a difference between a maximum battery module temperature and an average battery module temperature is greater than a change threshold of the difference between the maximum battery module temperature and the average battery module temperature, a temperature sensor fault occurs, time of a temperature change is earlier than time of the temperature sensor fault, a battery cell voltage sampling circuit is normal, a minimum battery cell voltage is less than a battery cell voltage abnormality threshold of battery thermal runaway, and a difference between a minimum battery cell voltage in a current sampling period and a minimum battery cell voltage in a previous sampling period is greater than a first threshold, the first threshold being a ratio of a threshold of a rate of change of the minimum battery cell voltage to preset times a battery cell voltage data sampling period, and the second threshold being a ratio of a threshold of a rate of change to a determination period of a rate of change.

7. An early warning apparatus, comprising:

an acquisition module (210) configured to acquire a battery cell voltage and a battery module temperature in real time;

a computation module (220) configured to compute a battery characteristic parameter according to the battery cell voltage and the battery module temperature; and

an early warning module (230) configured to give early warning under a condition that the battery characteristic parameter satisfies a preset condition;

**characterized in that** :

the early warning module is further configured to execute one of following actions:

give the early warning under the conditions that a maximum battery module temperature is greater than a battery temperature abnormality threshold of battery thermal runaway, a minimum battery cell voltage is less than a battery cell voltage abnormality threshold of battery thermal runaway, a difference between the minimum battery cell voltage in a current sampling period and a minimum battery cell voltage in a previous sampling period is greater than a first threshold, and a sampling point corresponding to the maximum battery module temperature and a sampling point corresponding to the minimum battery cell voltage are positioned in the same battery module, the first threshold being a ratio of a threshold of a rate of change of the minimum battery cell voltage to preset times a battery cell voltage data sampling period;

give the early warning under the conditions that a maximum battery module temperature is greater than a battery temperature abnormality threshold of battery thermal runaway, a difference between a temperature of a sampling point corresponding to a maximum temperature in a current detection period and a temperature of a sampling point corresponding to a maximum temperature in a previous sampling and detection period is greater than a second threshold, and within preset times a battery module temperature data sampling period, a difference between a maximum battery module temperature and an average battery module temperature is greater than a change threshold of the difference between the maximum temperature and the average temperature, the second threshold being a ratio of a threshold of a rate of change to a determination period of a rate of change; and

give the early warning under the conditions that a maximum battery module temperature is greater than a battery temperature abnormality threshold of battery thermal runaway, a difference between a temperature adjacent to a maximum temperature in a current sampling period and a temperature adjacent to a maximum temperature in a previous sampling period is greater than a second threshold, and a difference between a previous temperature or a subsequent temperature adjacent to the maximum battery module temperature and an average battery module temperature is greater than a change threshold of the difference between the temperature adjacent to the maximum battery module temperature and the average battery module temperature.

8. A computer device (12), comprising: a memory (28), a processor (16), and a computer program (40) that is stored on the memory and can run on the processor, **characterized by**:
the processor implementing the method of any one of claims 1-6 when executing the program.

9. A computer-readable storage medium, storing a computer program,
**characterized by**:
the program implementing the method of any one of claims 1-6 when executed by a processor.

**Patentansprüche**

1. Frühwarnverfahren, umfassend:

Erfassen einer Batteriezellenspannung und einer Batteriemodultemperatur in Echtzeit (S110);
Berechnen eines Batteriecharakteristikparameters gemäß der Batteriezellenspannung und der Batteriemodultemperatur (S120); und
Ausgeben einer Frühwarnung unter einer Bedingung, dass der Batteriecharakteristikparameter eine voreingestellte Bedingung erfüllt (S130);
**dadurch gekennzeichnet, dass**:
das Ausgeben einer Frühwarnung unter der Bedingung, dass der Batteriecharakteristikparameter eine voreingestellte Bedingung erfüllt, eine der folgenden Situationen umfasst:

Ausgeben der Frühwarnung unter den Bedingungen, dass eine maximale Batteriemodultemperatur größer als ein Batterietemperaturabnormalitätsschwellenwert des thermischen Durchgehens der Batterie ist, eine minimale Batteriezellenspannung kleiner als ein Batteriezellenspannungsabnormalitätsschwellenwert des thermischen Durchgehens der Batterie ist, eine Differenz zwischen der minimalen Batteriezellenspannung in einer aktuellen Abtastperiode und einer minimalen Batteriezellenspannung in einer vorherigen Abtastperiode größer als ein erster Schwellenwert ist und ein Abtastpunkt, der der maximalen Batteriemodultemperatur entspricht, und ein Abtastpunkt, der der minimalen Batteriezellenspannung entspricht, in demselben Batteriemodul positioniert sind, wobei der erste Schwellenwert ein Verhältnis eines Schwellenwerts einer Änderungsrate der minimalen Batteriezellenspannung zu voreingestellten Zeiten einer Batteriezellenspannungsdatenabtastperiode ist;
Ausgeben der Frühwarnung unter den Bedingungen, dass eine maximale Batteriemodultemperatur größer als ein Batterietemperaturabnormalitätsschwellenwert des thermischen Durchgehens der Batterie ist, eine Differenz zwischen einer Temperatur eines Abtastpunkts, der einer maximalen Temperatur in einer aktuellen Detektionsperiode entspricht, und einer Temperatur eines Abtastpunkts, der einer maximalen Temperatur in einer vorherigen Abtast- und Detektionsperiode entspricht, größer als ein zweiter Schwellenwert ist, und innerhalb voreingestellter Zeiten einer Batteriemodultemperaturdatenabtastperiode, eine Differenz zwischen einer maximalen Batteriemodultemperatur und einer durchschnittlichen Batteriemodultemperatur größer als ein Änderungsschwellenwert der Differenz zwischen der maximalen Temperatur und der durchschnittlichen Temperatur ist, wobei der zweite Schwellenwert ein Verhältnis eines Schwellenwerts einer Änderungsrate zu einer Bestimmungsperiode einer Änderungsrate ist; und

Ausgeben der Frühwarnung unter den Bedingungen, dass eine maximale Batteriemodultemperatur größer als ein Batterietemperaturabnormalitätsschwellenwert des thermischen Durchgehens der Batterie ist, eine Differenz zwischen einer Temperatur angrenzend an eine maximale Temperatur in einer aktuellen Abtastperiode und einer Temperatur angrenzend an eine maximale Temperatur in einer vorherigen Abtastperiode größer als ein zweiter Schwellenwert ist, und eine Differenz zwischen einer vorherigen Temperatur oder einer nachfolgenden Temperatur angrenzend an die maximale Batteriemodultemperatur, und einem durchschnittlichen Batteriemodultemperatur größer als ein Änderungsschwellenwert der Differenz zwischen der Temperatur angrenzend an die maximale Batteriemodultemperatur, und der durchschnittlichen Batteriemodultemperatur ist.

2. Verfahren nach Anspruch 1, wobei das Verfahren vor dem Ausgeben einer Frühwarnung unter der Bedingung, dass der Batteriecharakteristikparameter eine voreingestellte Bedingung erfüllt, ferner Folgendes umfasst: Bestimmen einer Schaltungsbedingung gemäß dem Batteriecharakteristikparameter; und

das Ausgeben einer Frühwarnung unter der Bedingung, dass der Batteriecharakteristikparameter eine voreingestellte Bedingung erfüllt, Folgendes umfasst:

Ausgeben der Frühwarnung unter der Bedingung, dass der Batteriecharakteristikparameter und die Schaltungsbedingung voreingestellte Bedingungen erfüllen.

3. Verfahren nach Anspruch 1 oder 2, wobei der Batteriecharakteristikparameter mindestens eine maximale Batteriemodultemperatur, eine minimale Batteriemodultemperatur, einen Abtastpunkt, der der maximalen Batteriemodultemperatur entspricht, einen Abtastpunkt, der der minimalen Batteriemodultemperatur entspricht, eine maximale Batteriezellenspannung, eine minimale Batteriezellenspannung, einen Abtastpunkt, der der maximalen Batteriezellenspannung entspricht, einen Abtastpunkt, der der minimalen Batteriezellenspannung entspricht, eine durchschnittliche Batteriemodultemperatur, eine Temperatur angrenzend an die maximale Batteriemodultemperatur, eine Temperatur angrenzend an die minimale Batteriemodultemperatur, eine Änderungsrate der maximalen Batteriemodultemperatur, eine Änderungsrate der Temperatur angrenzend an die maximale Batteriemodultemperatur in demselben Batteriemodul, eine Differenz zwischen der maximalen Batteriemodultemperatur und der durchschnittlichen Batteriemodultemperatur, eine Differenz zwischen einer Temperatur eines Abtastpunkts angrenzend an den Abtastpunkt, der der maximalen Batteriemodultemperatur entspricht, und der durchschnittlichen Batteriemodultemperatur und/oder eine Änderungsrate der minimalen Batteriezellenspannung umfasst.

4. Verfahren nach Anspruch 2, wobei die Schaltungsbedingung mindestens einen Leerlauffehler einer Batteriezellenspannungsabtastschaltung, einen Leerlauffehler einer Temperatursensorabtastschaltung, einen Kurzschlussfehler der Temperatursensorabtastschaltung, einen Fehler einer Abtastplatinenkommunikationsschaltung, einen Fehler einer Abtastplatinenstromversorgungsschaltung und/oder einer Abnormalität einer Kommunikationsantwortkennung einer Abtastplatine umfasst.

5. Verfahren nach Anspruch 2, wobei das Bestimmen einer Schaltungsbedingung gemäß dem Batteriecharakteristikparameter eine der folgenden Situationen umfasst:

Bestimmen, unter den Bedingungen, dass eine Differenz zwischen einer maximalen Batteriezellenspannung und einer minimalen Batteriezellenspannung größer als ein Spannungsdifferenzschwellenwert eines Leerlauffehlers einer Zellspannungsabtastschaltung ist und eine Differenz zwischen einer Positionszahl eines Abtastpunkts der maximalen Batteriezellenspannung und einer Positionszahl eines Abtastpunkts der minimalen Batteriezellenspannung gleich 1 ist, das heißt, dass der Abtastpunkt der maximalen Spannung und der Abtastpunkt der minimalen Spannung aneinander so angrenzen, dass ein Leerlauffehler an einer Abtastschaltung auftritt, die sich in der Mitte des Abtastpunkts der maximalen Batteriezellenspannung und des Abtastpunkts der minimalen Batteriezellenspannung befindet;

Bestimmen, unter der Bedingung, dass eine Spannung eines Temperatursensors größer als ein Spannungsschwellenwert ist, dass ein Leerlauffehler oder ein Kurzschlussfehler an einer Temperatursensorabtastschaltung auftritt; und

Bestimmen mindestens einer Bedingung eines Fehlers einer Abtastplatinenkommunikationsschaltung und eines Fehlers einer Abtastplatinenstromversorgungsschaltung unter den Bedingungen, dass mindestens die Batteriezellenspannungsdaten und/oder Batteriemodultemperaturdaten, die durch eine Abtastplatine hochgeladen werden, nicht aktualisiert werden und eine Kommunikationsantwortkennung der Abtastplatine abnormal ist.

6. Verfahren nach Anspruch 2, wobei das Ausgeben der Frühwarnung unter der Bedingung, dass der Batteriecharakteristikparameter und die Schaltungsbedingung voreingestellte Bedingungen erfüllen, eine der folgenden Situationen umfasst:

Ausgeben der Frühwarnung unter den Bedingungen, dass eine maximale Batteriemodultemperatur größer als ein Batterietemperaturabnormalitätsschwellenwert des thermischen Durchgehens der Batterie ist, ein Leerlauffehler an einer Batteriezellenspannungsabtastschaltung auftritt, ein Abtastpunkt der maximalen Batteriemodultemperatur und ein Leerlauffehlerpunkt der Batteriezellenspannungsabtastschaltung in demselben Modul positioniert sind und sich ein Temperatursensor in einem normalen Betriebszustand befindet;
Ausgeben der Frühwarnung unter den Bedingungen, dass eine maximale Batteriemodultemperatur größer als ein Batterietemperaturabnormalitätsschwellenwert des thermischen Durchgehens der Batterie ist, sich ein Temperatursensor in einem normalen Betriebszustand befindet, eine Kommunikationsantwortkennung einer Abtastplatine abnormal ist, ein Abtastpunkt der maximalen Batteriemodultemperatur und ein Abnormalitätspunkt der Kommunikationsantwortkennung der Abtastplatine in demselben Modul positioniert sind, und die Zeit, zu der die maximale Batteriemodultemperatur größer als der Batterietemperaturabnormalitätsschwellenwert des thermischen Durchgehens der Batterie ist, früher als die Zeit ist, zu der die Kommunikationsantwortkennung der Abtastplatine abnormal ist; und
Ausgeben der Frühwarnung unter den Bedingungen, dass eine Differenz zwischen einer Temperatur eines Abtastpunkts, der einer maximalen Temperatur in einer aktuellen Detektionsperiode entspricht, und einer Temperatur eines Abtastpunkts, der einer maximalen Temperatur in einer vorherigen Abtast- und Detektionsperiode entspricht, größer als ein zweiter Schwellenwert ist, innerhalb voreingestellter Zeiten einer Batteriemodultemperaturdatenerfassungsperiode, eine Differenz zwischen einer maximalen Batteriemodultemperatur und einer durchschnittlichen Batteriemodultemperatur größer als ein Änderungsschwellenwert der Differenz zwischen der maximalen Batteriemodultemperatur und der durchschnittlichen Batteriemodultemperatur ist, ein Temperatursensorfehler auftritt, die Zeit einer Temperaturänderung früher ist als der Zeitpunkt des Temperatursensorfehlers, eine Batteriezellenspannungsabtastschaltung normal ist, eine minimale Batteriezellenspannung kleiner ist als ein Batteriezellenspannungsabnormalitätsschwellenwert des thermischen Durchgehens der Batterie, und eine Differenz zwischen einer minimalen Batteriezellenspannung in einer aktuellen Abtastperiode und einer minimalen Batteriezellenspannung in einer vorherigen Abtastperiode größer ist als ein erster Schwellenwert, wobei der erste Schwellenwert ein Verhältnis eines Schwellenwerts einer Änderungsrate der minimalen Batteriezellenspannung zu voreingestellten Zeiten einer Batteriezellenspannungsdatenabtastperiode ist, und der zweite Schwellenwert ein Verhältnis eines Schwellenwerts einer Änderungsrate zu einer Bestimmungsperiode einer Änderungsrate ist.

7. Frühwarnvorrichtung, umfassend:

ein Erfassungsmodul (210), das zum Erfassen einer Batteriezellenspannung und einer Batteriemodultemperatur in Echtzeit ausgelegt ist;
ein Rechenmodul (220), das zum Berechnen eines Batteriecharakteristikparameters gemäß der Batteriezellenspannung und der Batteriemodultemperatur ausgelegt ist; und
ein Frühwarnmodul (230), das zum Ausgeben einer Frühwarnung unter einer Bedingung, dass der Batteriecharakteristikparameter eine voreingestellte Bedingung erfüllt, ausgelegt ist;
**dadurch gekennzeichnet, dass**:
das Frühwarnmodul ferner dazu konfiguriert ist, eine der folgenden Aktionen auszuführen:

Ausgeben der Frühwarnung unter den Bedingungen, dass eine maximale Batteriemodultemperatur größer als ein Batterietemperaturabnormalitätsschwellenwert des thermischen Durchgehens der Batterie ist, eine minimale Batteriezellenspannung kleiner als ein Batteriezellenspannungsabnormalitätsschwellenwert des thermischen Durchgehens der Batterie ist, eine Differenz zwischen der minimalen Batteriezellenspannung in einer aktuellen Abtastperiode und einer minimalen Batteriezellenspannung in einer vorherigen Abtastperiode größer als ein erster Schwellenwert ist und ein Abtastpunkt, der der maximalen Batteriemodultemperatur entspricht, und ein Abtastpunkt, der der minimalen Batteriezellenspannung entspricht, in demselben Batteriemodul positioniert sind, wobei der erste Schwellenwert ein Verhältnis eines Schwellenwerts einer Änderungsrate der minimalen Batteriezellenspannung zu voreingestellten Zeiten einer Batteriezellenspannungsdatenabtastperiode ist;

Ausgeben der Frühwarnung unter den Bedingungen, dass eine maximale Batteriemodultemperatur größer als ein Batterietemperaturabnormalitätsschwellenwert des thermischen Durchgehens der Batterie ist, eine Differenz zwischen einer Temperatur eines Abtastpunkts, der einer maximalen Temperatur in einer aktuellen Detektionsperiode entspricht, und einer Temperatur eines Abtastpunkts, der einer maximalen Temperatur in einer vorherigen Abtast- und Detektionsperiode entspricht, größer als ein zweiter Schwellenwert ist, und innerhalb voreingestellter Zeiten einer Batteriemodultemperaturdatenabtastperiode, eine Differenz zwischen einer maximalen Batteriemodultemperatur und einer durchschnittlichen Batteriemodultemperatur größer als ein Änderungsschwellenwert der Differenz zwischen der maximalen Temperatur und der durchschnittlichen Temperatur ist, wobei der zweite Schwellenwert ein Verhältnis eines Schwellenwerts einer Änderungsrate zu einer Bestimmungsperiode einer Änderungsrate ist; und

Ausgeben der Frühwarnung unter den Bedingungen, dass eine maximale Batteriemodultemperatur größer als ein Batterietemperaturabnormalitätsschwellenwert des thermischen Durchgehens der Batterie ist, eine Differenz zwischen einer Temperatur angrenzend an eine maximale Temperatur in einer aktuellen Abtastperiode und einer Temperatur angrenzend an eine maximale Temperatur in einer vorherigen Abtastperiode größer als ein zweiter Schwellenwert ist, und eine Differenz zwischen einer vorherigen Temperatur oder einer nachfolgenden Temperatur angrenzend an die maximale Batteriemodultemperatur, und einem durchschnittlichen Batteriemodultemperatur größer als ein Änderungsschwellenwert der Differenz zwischen der Temperatur angrenzend an die maximale Batteriemodultemperatur, und der durchschnittlichen Batteriemodultemperatur ist.

8. Computervorrichtung (12), umfassend: einen Speicher (28), einen Prozessor (16) und ein Computerprogramm (40), das auf dem Speicher gespeichert ist und auf dem Prozessor ablaufen kann, **gekennzeichnet durch**:
den Prozessor, der das Verfahren nach einem der Ansprüche 1-6 implementiert, wenn er das Programm ausführt.

9. Computerlesbares Speichermedium, das ein Computerprogramm speichert, **gekennzeichnet durch**:
das Programm, das das Verfahren nach einem der Ansprüche 1-6 implementiert, wenn es von einem Prozessor ausgeführt wird.

**Revendications**

1. Procédé d'avertissement précoce, comprenant :

acquérir, en temps réel (S110), une tension d'élément de batterie et une température de module de batterie ;
calculer un paramètre caractéristique de la batterie selon la tension d'élément de batterie et la température du module de batterie (S120) ; et
émettre un avertissement précoce dans une condition où le paramètre caractéristique de la batterie satisfait une condition prédéfinie (S130) ;
**caractérisé en ce que** :
le fait de donner un avertissement précoce dans la condition où le paramètre caractéristique de la batterie satisfait une condition prédéfinie comprend l'une des situations suivantes :

émettre l'avertissement précoce dans les conditions où une température maximale du module de batterie est supérieure à un seuil d'anomalie de température de batterie d'emballement thermique de batterie, une tension minimale d'élément de batterie est inférieure à un seuil d'anomalie de tension d'élément de batterie d'emballement thermique de batterie, une différence entre la tension minimale d'élément de batterie dans une période d'échantillonnage actuelle et une tension minimale d'élément de batterie dans une période d'échantillonnage précédente est supérieure à un premier seuil, et un point d'échantillonnage correspondant à la température maximale du module de batterie et un point d'échantillonnage correspondant à la tension minimale d'élément de batterie sont positionnés dans le même module de batterie, le premier seuil étant un rapport entre un seuil d'un taux de variation de la tension minimale d'élément de batterie et des temps prédéfinis d'une période d'échantillonnage des données de tension d'élément de batterie ;
émettre l'avertissement précoce dans les conditions où une température maximale du module de batterie est supérieure à un seuil d'anomalie de température de la batterie d'emballement thermique de batterie, une différence entre une température d'un point d'échantillonnage correspondant à une température maximale pendant une période de détection actuelle et une température d'un point d'échantillonnage correspondant à une température maximale pendant une période d'échantillonnage et de détection précédente est supérieure à un second seuil, et dans les temps prédéfinis d'une période d'échantillonnage des données de température du module de batterie, une différence entre une température maximale du module de batterie et une température moyenne du module de batterie est supérieure à un seuil de variation de la différence entre la température maximale et la température moyenne, le second seuil étant un rapport entre un seuil d'un taux de variation et une période de détermination d'un taux de variation ; et

émettre l'avertissement précoce dans les conditions où une température maximale du module de batterie est supérieure à un seuil d'anomalie de température de la batterie d'emballement thermique de batterie, une différence entre une température adjacente à une température maximale dans une période d'échantillonnage actuelle et une température adjacente à une température maximale dans une période d'échantillonnage précédente est supérieure à un second seuil, et une différence entre une température précédente ou une température suivante adjacente à la température maximale du module de batterie et une température moyenne du module de batterie est supérieure à un seuil de variation de la différence entre la température adjacente à la température maximale du module de batterie et la température moyenne du module de batterie.

2. Procédé selon la revendication 1, dans lequel, avant d'émettre un avertissement précoce dans la condition où le paramètre caractéristique de la batterie satisfait une condition prédéfinie, le procédé comprend en outre :

déterminer un état de circuit selon le paramètre caractéristique de la batterie ; et
le fait d'émettre un avertissement précoce dans la condition où le paramètre caractéristique de la batterie satisfait une condition prédéfinie comprend : émettre l'avertissement précoce dans la condition où le paramètre caractéristique de la batterie et l'état de circuit satisfont des conditions prédéfinies.

3. Procédé selon la revendication 1 ou 2, dans lequel le paramètre caractéristique de la batterie comprend au moins l'un des éléments parmi une température maximale du module de batterie, une température minimale du module de batterie, un point d'échantillonnage correspondant à la température maximale du module de batterie, un point d'échantillonnage correspondant à la température minimale du module de batterie, une tension maximale d'élément de batterie, une tension minimale d'élément de batterie, un point d'échantillonnage correspondant à la tension maximale d'élément de batterie, un point d'échantillonnage correspondant à la tension minimale d'élément de batterie, une température moyenne du module de batterie, une température adjacente à la température maximale du module de batterie, une température adjacente à la température minimale du module de batterie, un taux de variation de la température maximale du module de batterie, un taux de variation de la température adjacente à la température maximale du module de batterie dans le même module de batterie, une différence entre la température maximale du module de batterie et la température moyenne du module de batterie, une différence entre une température d'un point d'échantillonnage adjacent au point d'échantillonnage correspondant à la température maximale du module de batterie et la température moyenne du module de batterie, et un taux de variation de la tension minimale d'élément de batterie.

4. Procédé selon la revendication 2, dans lequel l'état de circuit comprend au moins l'un parmi une défaillance de circuit ouvert d'un circuit d'échantillonnage de tension d'élément de batterie, une défaillance de circuit ouvert d'un circuit d'échantillonnage de capteur de température, une défaillance de court-circuit du circuit d'échantillonnage de capteur de température, une défaillance d'un circuit de communication de carte d'échantillonnage, une défaillance d'un circuit d'alimentation électrique de carte d'échantillonnage et une anomalie d'un identifiant de réponse de communication d'une carte d'échantillonnage.

5. Procédé selon la revendication 2, dans lequel la détermination d'un état de circuit selon le paramètre caractéristique de la batterie comprend l'une des situations suivantes :

déterminer, dans les conditions où une différence entre une tension maximale d'élément de batterie et une tension minimale d'élément de batterie est supérieure à un seuil de différence de tension d'une défaillance de circuit ouvert d'un circuit d'échantillonnage de tension d'élément, et une différence entre un numéro de position d'un point d'échantillonnage de la tension maximale d'élément de batterie et un numéro de position d'un point d'échantillonnage de la tension minimale d'élément de batterie est égale à 1, c'est-à-dire le point d'échantillonnage de la tension maximale et le point d'échantillonnage de la tension minimale sont adjacents l'un à l'autre, où une défaillance de circuit ouvert se produit sur un circuit d'échantillonnage qui se trouve au milieu du point d'échantillonnage de la tension maximale d'élément de batterie et du point d'échantillonnage de la tension minimale d'élément de batterie ;

déterminer, dans la condition où une tension d'un capteur de température est supérieure à un seuil de tension, où une défaillance de circuit ouvert ou une défaillance de court-circuit se produit sur un circuit d'échantillonnage de capteur de température ; et

déterminer au moins une condition de défaillance d'un circuit de communication de carte d'échantillonnage et de défaillance d'un circuit d'alimentation électrique de carte d'échantillonnage dans les conditions où au moins l'une des données de tension d'élément de batterie ou des données de température du module de batterie téléversées par une carte d'échantillonnage ne sont pas mises à jour, et où un identifiant de réponse de communication de la carte d'échantillonnage est anormal.

6. Procédé selon la revendication 2, dans lequel le fait d'émettre l'avertissement précoce dans la condition où le paramètre caractéristique de la batterie et l'état du circuit satisfont des conditions prédéfinies comprend l'une quelconque des situations suivantes :

émettre l'avertissement précoce dans les conditions où une température maximale du module de batterie est supérieure à un seuil d'anomalie de température de la batterie d'emballement thermique de batterie, une défaillance de circuit ouvert se produit sur un circuit d'échantillonnage de tension d'élément de batterie, un point d'échantillonnage de la température maximale du module de batterie et un point de défaillance de circuit ouvert du circuit d'échantillonnage de tension d'élément de batterie sont situés dans le même module, et un capteur de température est dans un état de fonctionnement normal ;

émettre l'avertissement précoce dans les conditions où une température maximale du module de batterie est supérieure à un seuil d'anomalie de température de la batterie d'emballement thermique de batterie, un capteur de température est dans un état de fonctionnement normal, un identifiant de réponse de communication d'une carte d'échantillonnage est anormal, un point d'échantillonnage de la température maximale du module de batterie et un point d'anomalie de l'identifiant de réponse de communication de la carte d'échantillonnage sont situés dans le même module, et le temps lorsque la température maximale du module de batterie est supérieure au seuil d'anomalie de température de la batterie d'emballement thermique de batterie est antérieur au temps lorsque l'identifiant de réponse de communication de la carte d'échantillonnage est anormal ; et

émettre l'avertissement précoce dans les conditions où une différence entre une température d'un point d'échantillonnage correspondant à une température maximale pendant une période de détection actuelle et une température d'un point d'échantillonnage correspondant à une température maximale pendant une période d'échantillonnage et de détection précédente est supérieure à un second seuil, dans les temps prédéfinis d'une période d'acquisition des données de température d'un module de batterie, une différence entre une température maximale du module de batterie et une température moyenne du module de batterie est supérieure à un seuil de variation de la différence entre la température maximale du module de batterie et la température moyenne du module de batterie, une défaillance du capteur de température se produit, le temps de la variation de température est antérieur au temps de la défaillance du capteur de température, un circuit d'échantillonnage de tension d'élément de batterie est normal, une tension minimale d'élément de batterie est inférieure à un seuil d'anomalie de tension d'élément de batterie d'emballement thermique de batterie, et une différence entre une tension minimale d'élément de batterie dans une période d'échantillonnage actuelle et une tension minimale d'élément de batterie dans une période d'échantillonnage précédente est supérieure à un premier seuil, le premier seuil étant un rapport entre un seuil d'un taux de variation de la tension minimale d'élément de batterie et des temps prédéfinis d'une période d'échantillonnage des données de tension d'élément de batterie, et le second seuil étant un rapport entre un seuil d'un taux de variation et une période de détermination d'un taux de variation.

7. Appareil d'avertissement précoce, comprenant :

un module d'acquisition (210) configuré pour acquérir, en temps réel, une tension d'élément de batterie et une température d'un module de batterie ;

un module de calcul (220) configuré pour calculer un paramètre caractéristique de la batterie selon la tension d'élément de batterie et la température du module de batterie ; et

un module d'avertissement précoce (230) configuré pour émettre un avertissement précoce dans le cas où le paramètre caractéristique de la batterie satisfait une condition prédéfinie ;

**caractérisé en ce que** :

le module d'avertissement précoce est en outre configuré pour exécuter l'une des actions suivantes :

émettre l'avertissement précoce dans les conditions où une température maximale du module de batterie est supérieure à un seuil d'anomalie de température de batterie d'emballement thermique de batterie, une tension minimale d'élément de batterie est inférieure à un seuil d'anomalie de tension d'élément de batterie d'emballement thermique de batterie, une différence entre la tension minimale d'élément de batterie dans une période d'échantillonnage actuelle et une tension minimale d'élément de batterie dans une période d'échantillonnage précédente est supérieure à un premier seuil, et un point d'échantillonnage correspondant à la température maximale du module de batterie et un point d'échantillonnage correspondant à la tension minimale d'élément de batterie sont positionnés dans le même module de batterie, le premier seuil étant un rapport entre un seuil d'un taux de variation de la tension minimale d'élément de batterie et des temps prédéfinis d'une période d'échantillonnage des données de tension d'élément de batterie ;

émettre l'avertissement précoce dans les conditions où une température maximale du module de batterie est supérieure à un seuil d'anomalie de température de la batterie d'emballement thermique de batterie, une différence entre une température d'un point d'échantillonnage correspondant à une température maximale pendant une période de détection actuelle et une température d'un point d'échantillonnage correspondant à une température maximale pendant une période d'échantillonnage et de détection précédente est supérieure à un second seuil, et dans les temps prédéfinis d'une période d'échantillonnage des données de température du module de batterie, une différence entre une température maximale du module de batterie et une température moyenne du module de batterie est supérieure à un seuil de variation de la différence entre la température maximale et la température moyenne, le second seuil étant un rapport entre un seuil d'un taux de variation et une période de détermination d'un taux de variation ; et

émettre l'avertissement précoce dans les conditions où une température maximale du module de batterie est supérieure à un seuil d'anomalie de température de la batterie d'emballement thermique de batterie, une différence entre une température adjacente à une température maximale dans une période d'échantillonnage actuelle et une température adjacente à une température maximale dans une période d'échantillonnage précédente est supérieure à un second seuil, et une différence entre une température précédente ou une température suivante adjacente à la température maximale du module de batterie et une température moyenne du module de batterie est supérieure à un seuil de variation de la différence entre la température adjacente à la température maximale du module de batterie et la température moyenne du module de batterie.

8. Dispositif informatique (12), comprenant : une mémoire (28), un processeur (16) et un programme informatique (40) qui est stocké dans la mémoire et peut être exécuté sur le processeur, **caractérisé par** :
le processeur mettant en œuvre le procédé selon l'une quelconque des revendications 1-6 lors de l'exécution du programme.

9. Support de stockage lisible par ordinateur, stockant un programme informatique, **caractérisé par** :
le programme mettant en œuvre le procédé selon l'une quelconque des revendications 1-6 lorsqu'il est exécuté par un processeur.

Fig. 1A

A battery cell voltage and a battery module temperature are acquired in real time — S110

A battery characteristic parameter is computed according to the battery cell voltage and the battery module temperature — S120

Early warning is given under the condition that the battery characteristic parameter satisfies a preset condition — S130

Fig. 1B

Battery system

Battery module | Battery module | ••• | Battery module | Battery module

Voltage detection

Temperature detection

Determination of voltage change characteristic

Determination of temperature change characteristic

Disconnection of high-voltage circuit

Determination of voltage abnormality position

Determination of temperature abnormality position

Determination of electrical fault position

Fault information → Big data monitoring platform

Joint positioning and determination

Prompt personnel to get away from vehicle → Instrument

Battery management system

Fig. 1C

| Battery module 7 | Battery module 8 | Battery module 9 | Battery module 10 | Battery module 11 | Battery module 12 |

| Master control board | Slave control board 1 | Slave control board 2 | Slave control board 3 | Slave control board 4 | Slave control board 5 | Slave control board 6 |

| Battery module 6 | Battery module 5 | Battery module 4 | Battery module 3 | Battery module 2 | Battery module 1 |

Fig. 2

210

220

230

| Acquisition module | Computation module | Early warning module |

Fig. 3

**EP 4 102 615 B1**

REFERENCES CITED IN THE DESCRIPTION

**Patent documents cited in the description**

- CN 210442486 U